# EUROPEAN PATENT APPLICATION

(11) **EP 4 852 681 A1**
(43) Date of publication of application: **09.12.2026**
(21) Application number: 24937218.6
(22) Date of filing: 22.04.2024
(51) Int. Cl.: H10K 59/80, G02F 1/1333, G02F 1/167, G02F 1/1675, B32B 7/12

(54) **DISPLAY DEVICE**

(71) Applicant: LG Electronics Inc., Yeongdeungpo-gu Seoul 07336 (KR)
(72) Inventor: KIM, Huisik, Seoul 06772 (KR); HAN, Seokbong, Seoul 06772 (KR); SHIN, Minchul, Seoul 06772 (KR); KIM, Chulki, Seoul 06772 (KR)
(74) Representative: Schornack, Oliver
(86) International application number: PCT/KR2024/005384
(87) International publication number: WO 2025/225743

(57) **Abstract**

This display device includes: a display module; a top case including a front part covering the front perimeter of the display module and a side part covering the side perimeter of the display module; and four bar-shaped skin panels disposed at right angles to each other on the front part and overlapping each other at the corners of the top case. Each of the four skin panels includes: electronic paper for outputting a specific color or image according to a signal; a transparent decorative sheet located on the front surface of the electronic paper; and a double-sided tape located on the rear surface of the electronic paper and fixed to the front part. The display device can improve a design effect by changing the color of the front perimeter.

## Description

### [TECHNICAL FIELD]

The present disclosure relates to a display device capable of changing the color of a bezel.

### [BACKGROUND ART]

With growth of information society, demand for various display devices has increased. In order to satisfy such demand, in recent years, a liquid crystal display (LCD), a field emission display (FED), a plasma display panel (PDP), and an electroluminescent device have been developed as display devices.

A liquid crystal panel of the liquid crystal display includes a liquid crystal layer and a TFT substrate and a color filter substrate opposite each other in the state in which the liquid crystal layer is interposed therebetween, wherein a picture is displayed using light provided from a backlight unit.

An active matrix type organic light-emitting display has come onto the market as an example of the electroluminescent device. Since the organic light-emitting display is self-emissive, the organic light-emitting display has no backlight, compared to the liquid crystal display, and has merits in terms of response time and viewing angle, and therefore the organic light-emitting display has attracted attention as a next-generation display.

Recently, materials such as OLEDs, which are self-illuminating without a backlighting structure on the backside, have allowed for the realization of bendable display modules, enabling the realization of curved display devices.

### [DISCLOSURE]

### [TECHNICAL PROBLEM]

An objective of the present disclosure is to provide a display device including a skin panel capable of changing a color of a bezel around a front surface of the display device.

### [TECHNICAL SOLUTION]

A display device is provided, the display device including: a display module; a top casing including a front portion covering a peripheral region of a front surface of the display module and a side portion disposed around and covering a side surface of the display module; and four bar-shaped skin panels disposed on the front portion, adjacent ones of the four skin panels being arranged at right angles to each other and disposed to overlap each other at corners of the top casing, wherein each of the four skin panels includes: electronic paper configured to output a specific color or image according to a signal; a transparent decoration sheet disposed on a front surface of the electronic paper; and double-sided tape disposed on a rear surface of the electronic paper and fixing the electronic paper to the front portion.

The electronic paper may include: an extension portion protruding from a first end portion of the electronic paper beyond the decoration sheet and disposed under the electronic paper of a skin panel adjacent thereto so as to overlap therewith; and a signal line extending from the extension portion.

The front portion of the top casing may include a hole through which the signal line passes.

The signal line may pass through a space between the side surface of the display module and the side portion of the top casing and may be connected to a controller disposed on a rear surface of the display module.

The display device may further include a gap rib protruding from the side portion of the top casing and maintaining a gap between the side portion of the top casing and the side surface of the display module to provide the space through which the signal line passes.

The front portion of the top casing may include a recess recessed therein in a rearward direction at a position corresponding to the extension portion of the electronic paper, and the recess may include an inclined portion formed in an area along which the extension portion extends.

A second end portion of the electronic paper may have a shape corresponding to a shape of a second end portion of the decoration sheet, and the extension portion may be disposed under a second end portion of the skin panel adjacent thereto.

The display device may further include a lifting-prevention tape coupled to a front surface of the extension portion and a rear surface of the skin panel disposed on top of the extension portion.

Both opposing end portions of the decoration sheet may each include an oblique edge inclined with respect to a longitudinal direction of the decoration sheet so as to abut an end portion of an adjacent decoration sheet at a corner of the top casing, and the extension portion may protrude in a triangular shape from a first end portion of the decoration sheet.

The skin panels may include: a pair of first skin panels in each of which both opposing end portions of the decoration sheet face the side portion of the top casing; and a second skin panel disposed between the pair of first skin panels, wherein both opposing end portions of the decoration sheet of the second skin panel respectively abut the decoration sheets of the first skin panels adjacent to the second skin panel.

The display device may further include an optically clear adhesive (OCA) layer disposed between the decoration sheet and the electronic paper, and
a first end portion of the optically clear adhesive layer may be positioned closer to a second end portion of the decoration sheet than a first end portion of the decoration sheet is.

The electronic paper may include:
a display region in which a specific color or image is output; and
a non-display edge disposed around the display region, and
the decoration sheet may include
a chamfer formed in an edge of a front surface thereof in an area corresponding to the non-display edge.

The side portion of the top casing may protrude in a frontward direction beyond the front portion by a distance equal to or greater than a height of the skin panel.

### [ADVANTAGEOUS EFFECTS]

The display device according to an aspect of the present disclosure may improve an aesthetic effect by changing a color around a front surface thereof.

In addition, the display device according to an aspect of the present disclosure may reduce the manufacturing costs of the skin panels by arranging four modular skin panels at right angles to one another to implement a rectangular frame structure.

In addition, the display device according to an aspect of the present disclosure may be driven with low power using electronic paper and may provide a unified design by minimizing a gap caused by non-output regions between the skin panels.

The effects obtainable from the present disclosure are not limited to those mentioned above, and other effects not mentioned will be apparent to one having ordinary skill in the art from the following description.

### [DESCRIPTION OF DRAWINGS]

FIG. 1 is a block diagram illustrating components of a display device according to the present disclosure;
FIG. 2 is a perspective view illustrating an example of the display device according to the present disclosure.
FIG. 3 is a cross-sectional view illustrating a skin panel of the display device according to the present disclosure.
FIG. 4 is a view illustrating a skin panel according to a first embodiment of the display device of the present disclosure.
FIG. 5 is an exploded perspective view illustrating a corner portion according to the first embodiment of the display device of the present disclosure.
FIG. 6 is a cross-sectional view taken along line A-A of FIG. 2.
FIG. 7 is a view illustrating a skin panel according to a second embodiment of the display device of the present disclosure.
FIG. 8 is a view illustrating a first skin panel according to the second embodiment of the display device of the present disclosure.
FIG. 9 is a view illustrating a second skin panel according to the second embodiment of the display device of the present disclosure.
FIG. 10 is an exploded perspective view illustrating a corner portion of a skin panel according to the second embodiment of the display device of the present disclosure.
FIG. 11 is a cross-sectional view illustrating a skin panel of the display device according to the present disclosure.
FIG. 12 is a cross-sectional view illustrating an edge portion of the display device of the present disclosure.

### [DETAILED DESCRIPTION]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

An image display device described in this specification is, for example, an intelligent image display device having a computer supporting function in addition to a broadcast reception function, wherein an Internet function may be added while the broadcast reception function is devotedly performed, whereby an interface that is more conveniently used, such as a handwriting type input device, a touchscreen, or a space remote control, may be provided. In addition, the image display device may be connected to the Internet or a computer through support of a wired or wireless Internet function, whereby various functions, such as e-mail, web browsing, banking, or gaming, may be executed. For such various functions, a standardized general-purpose OS may be used.

In the image display device described in the present disclosure, therefore, various applications may be freely added or deleted, for example, on a general-purpose OS kernel, whereby various user friendly functions may be executed. More specifically, the image display device may be a network TV, an Hbb TV, or a smart TV, and is applicable to a smartphone depending on circumstances.

### [Figure 1]

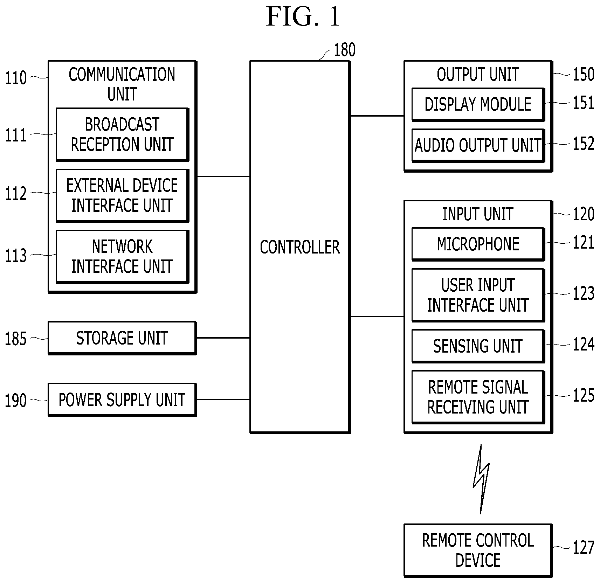

FIG. 1 is a block diagram illustrating components of a display device 100.

The display device 100 may include a communication unit 110, an input unit 120, a sensing unit 124, an output unit 150, a controller 180, a storage unit 185, and a power supply 190. The configuration shown in FIG. 1 may include only some of the components, and one configuration may perform two functions.

The communication unit 110 may include a broadcast reception unit including a tuner unit and a demodulator. The tuner unit of the broadcast reception unit may select a broadcast signal corresponding to a channel selected by a user or any one of all pre-stored channels, among broadcast signals received through an antenna (not shown) or a cable (not shown). The tuner unit 111 may convert the selected broadcast signal into an intermediate frequency signal or a baseband video or audio signal.

The tuner unit may sequentially select broadcast signals of all broadcast channels stored through a channel memory function, among received broadcast signals, and may convert each of the selected broadcast signals into an intermediate frequency signal or a baseband video or audio signal

The demodulation unit of the broadcast reception unit 111 may receive the digital IF (DIF) signal converted by the tuner unit, and may perform demodulation. After performing demodulation and channel decryption, the demodulation unit may output a stream signal (TS). At this time, the stream signal may be a multiplexed image, audio, or data signal.

The stream signal output from the demodulation unit may be input to the controller 180. After performing demultiplexing and image/audio signal processing, the controller 180 may output an image through the display module 151, and may output audio through the audio output unit 152.

An external device interface unit 112 may connect an external device to the display device 100 to receive an image signal, an audio signal, and a control signal from the external device. The interface unit 112 may be connected by wire/wireless to external devices such as a Digital Versatile Disk (DVD), a Blu-ray, a game device, a camera, a camcorder, a computer (laptop), and the like.

The external device interface unit 112 transmits video, audio, or data signals inputted externally to the controller 180 of the display device 100 through the connected external device. In addition, the video, audio, or data signals processed by the controller 180 may be outputted to the connected external device.

The external device interface section 112 may include a wired type and a wireless type. The wired type includes a physical terminal provided on the display device (100), and the wireless type may be connected to an external device through an antenna that receives a wireless signal.

The wired type may include a USB terminal, a CVBS (Composite Video Banking Sync) terminal, a component terminal, an S-video terminal (analog), a DVI (Digital Visual Interface) terminal, an HDMI (High Definition Multimedia Interface) terminal, an RGB terminal, a D-SUB terminal, etc., so that video and audio signals from the external device can be input to the display device 100.

The wireless type may perform short-range wireless communication with other electronic devices located nearby. The display device 100 may be connected to other electronic devices via networks according to communication standards such as Bluetooth, Radio Frequency Identification (RFID), Infrared Data Association (IrDA), Ultra Wideband (UWB), ZigBee, Digital Living Network Alliance (DLNA), etc.

The network interface unit 113 may access a prescribed web page through a connected network or another network linked to the connected network. That is, the network interface unit 113 may transmit and receive data with a corresponding server by accessing the prescribed web page through the network. In addition, the network interface unit 113 may receive contents or data provided by a content provider or a network operator.

That is, contents such as movies, advertisements, games, VODs, and broadcast signals provided from content providers or network providers and information related to such contents may be received through the network. In addition, update information and update files of firmware provided by the network operator may be received. In addition, data may be transmitted to the Internet or content provider or network operator.

In addition, the network interface unit 113 may select a desired application from applications opened to the public and receive the selected application through the network.

According to an embodiment, when a game application is executed in the display device, the network interface unit 113 may transmit or receive prescribed data to or from a user terminal connected to the display device via the network. Also, prescribed data may be transmitted or received with a server that stores game scores

The input unit 120 may include a microphone 121 that collects sound, a user input unit 123 that detects a user's command, a sensor unit that senses a state and surrounding state of the display device, and a remote signal reception unit 125 that receives a signal of a remote controller 127.

The microphone 121 may recognize a user's voice or surrounding sound, and in particular, receive a user's voice and process it as electrical audio data. Various noise cancellation algorithms for removing noise generated in the process of receiving an external audio signal may be implemented in the microphone 121.

The microphone 121 may simply collect user's voice, convert the collected voice into audio data, and store it in the storage unit 185 or transmit it to the external device via the communication unit 110, and may also perform a function as the user input unit 123 in a manner of analyzing the audio data and recognizing it as a user command.

In addition to the main body of the display device 100, the microphone 121 may be mounted on the remote controller 127, which will be described later, and the corresponding audio data may be forwarded to the controller 180 through the remote signal reception unit 125.

The user input unit 123 is a device to which a user inputs a control command for controlling the display device. The user input unit 123 may include a keypad, a button, a touch pad, a touch screen, etc.

When the user input unit 123 includes a hard key button, a user may input a command related to the display device 100 through a push operation of the hard key button. When the user input unit 123 is provided with a touchscreen, the user may input a command related to display device 100 to remote controller 127 by touching the soft key of the touchscreen.

In addition, the user input unit 123 may include various types of input means that the user can operate, such as a scroll key, a jog key, etc., and the present embodiment does not limit the scope of the right of the present disclosure.

Recently, as the size of a bezel of the display device 100 decreases, the display device 100 tends to minimize the user input unit 123 of the physical button type exposed externally. Instead, a minimum physical button is located on a rear side or a lateral side, and a user input may be received from a touchpad or the remote controller 127 through a remote signal reception unit 125 that will be described later.

The remote signal reception unit 125 may input a command related to the display device 100 through the remote controller 127 having the user input unit 123. The remote signal reception unit 125 is a sort of the user input unit 123 and may belong to a wireless communication unit because it receives signals from the remote controller 127 according to various communication methods such as Radio Frequency (RF) communication method, Infrared (IR) communication method, etc.

The sensing unit 124 refers to a device that detects a change in the display device 100 or an external change. For example, the sensing unit 124 may include at least one of a proximity sensor, an illumination sensor, a touch sensor, an Infrared (IR) sensor, an ultrasonic sensor, an optical sensor (e.g., a camera), a voice sensor (e.g., a microphone), a battery gauge, an environment sensor (e.g., a hygrometer, a thermometer, etc.), and the like.

Recently, a display device 100 that can move or change a direction of a display has emerged, and a gyro sensor, an acceleration sensor and the like may be provided to detect a posture of the display device.

Based on the information collected by the sensing unit 124, the controller 180 may check the state of the display device 100 and notify a user of a problem when the problem occurs or adjust it by itself, thereby controlling the display device 100 to maintain a best state.

In addition, the content, image quality, and size of an image provided to the display module 151 may be controlled differently depending on a viewer, a surrounding illumination and the like sensed by the sensing unit 124, thereby providing an optimal viewing environment. As smart TVs advance, functions mounted on the display device increase, and the sensing unit 124 is also increasing correspondingly.

The output unit 150 is a device that provides visual and auditory information to a user through the display device, and may include the display module 151 and the audio output unit 152.

The display module 151 may convert an image signal, a data signal, an OSD signal, and a control signal processed by the controller 180 or an image signal, a data signal, and a control signal received from the interface unit to generate a driving signal. The display module 151 may include a display panel having a plurality of pixels.

Each of the plurality of pixels in the display panel may include RGB subpixels. Alternatively, each of the plurality of pixels in the display panel may include RGBW subpixels. The display module 151 may convert an image signal, a data signal, an OSD signal, and a control signal processed by the controller 180 to generate a driving signal for the plurality of pixels.

A plasma display panel (PDP), a liquid crystal display (LCD), an organic light-emitting diode (OLED), or a flexible display may be used as the display module 151, and a 3D display may also be used. The 3D display 151 may be classified as a non-glasses type display or a glasses type display.

The display device 100 includes a display module 151, which occupies a major portion of the front surface thereof, and a casing configured to cover the rear surface and the side surface of the display module 151, the casing being configured to package the display module 151.

In recent years, the display device 100 may use a flexible display unit 151, such as a light-emitting diode (LED) or an organic light-emitting diode (OLED), in order to implement a curved screen in addition to a flat screen.

Light is supplied to an LCD, which was mainly used conventionally, through a backlight unit, since the LCD is not self-emissive. The backlight unit is a device that supplies light emitted from a light source to a liquid crystal uniformly located in front thereof. As the backlight unit has been gradually thinned, a thin LCD has been implemented. However, it is difficult to implement the backlight unit using a flexible material. If the backlight unit is curved, it is difficult to supply uniform light to the liquid crystal, whereby the brightness of a screen is changed.

In contrast, the LED or the OLED may be implemented so as to be curved, since an element constituting each pixel is self-emissive, and therefore no backlight unit is used. In addition, since each element is self-emissive, the brightness of the element is not affected even though the positional relationship between adjacent elements is changed, and therefore it is possible to implement a curved display module 151 using the LED or the OLED.

An organic light-emitting diode (OLED) panel appeared in earnest in mid-2010 and has rapidly replaced the LCD in the small- or medium-sized display market. The OLED is a display manufactured using a self-emissive phenomenon of an organic compound in which the organic compound emits light when current flows in the organic compound. The response time of the OLED is shorter than the response time of the LCD, and therefore afterimages hardly appear when video is implemented.

The OLED is an emissive display product that uses three fluorescent organic compounds having a self-emissive function, such as red, green, and blue fluorescent organic compounds and that uses a phenomenon in which electrons injected at a negative electrode and a positive electrode and particles having positive charges are combined in the organic compounds to emit light, and therefore a backlight unit, which deteriorates color, is not needed.

A light-emitting diode (LED) panel is based on technology of using one LED element as one pixel. Since it is possible to reduce the size of the LED element, compared to a conventional device, it is possible to implement a curved display module 151. The conventional device, which is called an LED TV, uses the LED as a light source of a backlight unit that supplies light to the LCD, and therefore the LED does not constitute a screen.

The display panel may include a plurality of pixels R, G, and B. The plurality of pixels R, G, and B may be formed at intersections between a plurality of data lines and a plurality of gate lines. The plurality of pixels R, G, and B may be disposed or arranged in a matrix form.

For example, the plurality of pixels R, G, and B may include a red subpixel 'R', a green subpixel 'G', and a blue subpixel 'B'. The plurality of pixels R, G, and B may include a white subpixel 'W'.

The side of the display module 151 on which a picture is displayed may be referred to as a front side or a front surface. When the display module 151 displays the picture, the side of the display module 151 from which the picture cannot be viewed may be referred to as a rear side or a rear surface. Meanwhile, the display module 151 may be constituted by a touchscreen, whereby an input device may also be used in addition to an output device.

The audio output unit 152 receives an audio signal processed by the controller 180 and outputs the same as audio.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

The controller 180 may demultiplex a stream input through the tuner unit, the demodulation unit the external device interface unit 112, or the network interface unit 113, or may process demultiplexed signals to generate and output a signal for image or audio output.

An image signal processed by the controller 180 may be input to the display module 151, which may display an image corresponding to the image signal. In addition, the image signal processed by the controller 180 may be input to an external output device through the external device interface unit 112.

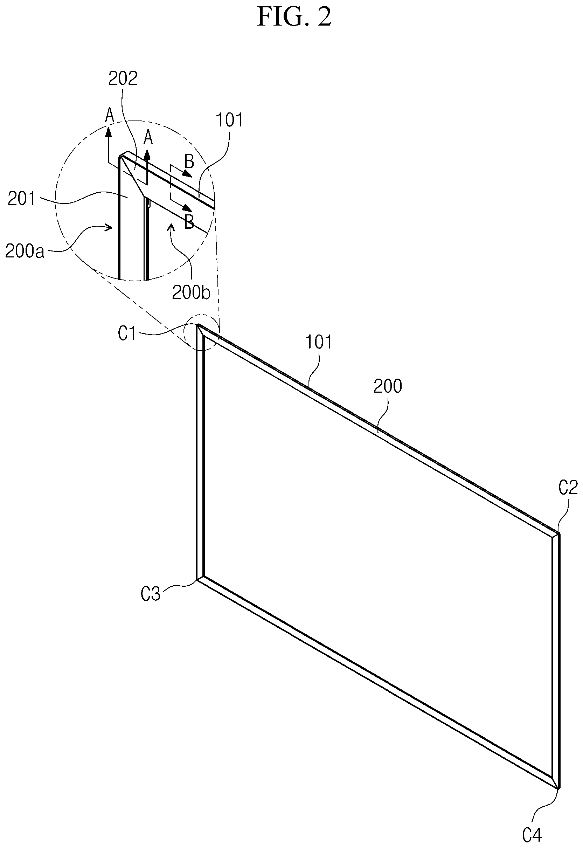

An audio signal processed by the controller 180 may be output through the audio output unit 152. In addition, the audio signal processed by the controller 180 may be input to an external output device through the external device interface unit 112. Although not shown in FIG. 2, the controller 180 may include a demultiplexing unit and an image processing unit.

Further, the controller 180 may control the overall operation of the display device 100. For example, the controller 180 may control the tuner unit such that a broadcast corresponding to a channel selected by a user or a pre-stored channel is tuned.

In addition, the controller 180 may control the display device 100 according to a user command input through the user input interface unit or an internal program. Meanwhile, the controller 180 may control the display module 151 to display an image. At this time, the image displayed on the display module 151 may be a still image or video, or may be a 2D image or a 3D image.

Meanwhile, the controller 180 may perform control such that a predetermined 2D object is displayed in an image displayed on the display module 151. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

Meanwhile, the display device 100 may further include a photographing unit (not shown). The photographing unit may photograph a user. The photographing unit may be implemented by one camera; however, the present disclosure is not limited thereto. The photographing unit may be implemented by a plurality of cameras. Meanwhile, the photographing unit may be embedded in the display device 100 above the display module 151, or may be separately disposed. Image information photographed by the photographing unit may be input to the controller 180.

The controller 180 may recognize the location of a user based on an image captured by the photographing unit. For example, the controller 180 may recognize the distance between the user and the display device 100 (z-axis coordinate). Further, the controller 180 may recognize an x-axis coordinate and a y-axis coordinate in the display module 151 corresponding to the location of the user.

The controller 180 may sense user gesture based on the image captured by the photographing unit, a signal sensed by the sensor unit, or a combination thereof.

The storage unit 185 may store programs for signal processing and control in the controller 180, and may store a processed image, audio, or data signal. For example, the storage unit 185 may store application programs designed to execute various tasks that can be processed by the controller 180, and may selectively provide some of the stored application programs in response to request of the controller 180.

Programs stored in the storage unit 185 are not particularly restricted as long as the programs can be executed by the controller 180. The storage unit 185 may temporarily store an image, audio, or data signal received from an external device through the external device interface unit 112. The storage unit 185 may store information about a predetermined broadcast channel through a channel memory function, such as a channel map.

FIG. 1 shows an embodiment in which the storage unit 185 and the controller 180 are separately provided; however, the present disclosure is not limited thereto. The storage unit 185 may be included in the controller 180.

The storage unit 185 may include at least one of a volatile memory (e.g., DRAM, SRAM, or SDRAM), a nonvolatile memory (e.g., flash memory), a hard disk drive (HDD), and a solid-state drive (SSD).

The power supply 190 may supply power to the components of the display device 100. In particular, the power supply may supply power to the controller 180, which may be implemented in the form of a system on chip (SOC), the display module 151 for image display, and the audio output unit 152 for audio output.

Specifically, the power supply 190 may include an AC/DC converter (not shown) configured to convert AC power into DC power and a DC/DC converter (not shown) configured to convert the level of the DC power.

The power supply 190 serves to distribute power supplied from the outside to the respective components of the display device. The power supply 190 may be directly connected to an external power supply in order to supply AC power, or may include a battery so as to be used by charging.

In the former case, a cable is used, and the power supply is difficult to move or the movement range of the power supply is limited. In the latter case, the power supply is free to move, but the weight of the power supply is increased in proportion to the weight of the battery, the volume of the power supply is increased, and, for charging, the power supply must be directly connected to a power cable or must be coupled to a charging holder (not shown) that supplies power for a predetermined time.

The charging holder may be connected to the display device through a terminal exposed to the outside, or the battery mounted in the power supply may be charged in a wireless manner when the power supply approaches the charging holder.

The block diagram of the display device 100 shown in FIG. 1 is for an embodiment of the present disclosure, and elements of the block diagram may be integrated, added, or omitted depending on specifications of an actually implemented display device 100.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

FIG. 2 is a front perspective view illustrating an example of a display device.

Referring to FIG. 2, the display device 100 may have a rectangular main body including a pair of long sides and a pair of short sides.

Although the long sides extending in a horizontal direction and the short sides extending in a vertical direction are illustrated in the drawing, the long sides and the short sides may have the same length, or the long sides may be arranged in the vertical direction.

For convenience of description, an embodiment in which sides extending in a horizontal direction (x-axis direction) are long sides and sides extending in a vertical direction (y-axis direction) are short sides will be described; however, as described above, the present disclosure is not limited thereto.

A side on which the display device 100 displays an image may be referred to as a frontward side or a front surface. When the display device 100 displays the image, a side from which the image cannot be viewed may be referred to as a rearward side or a rear surface.

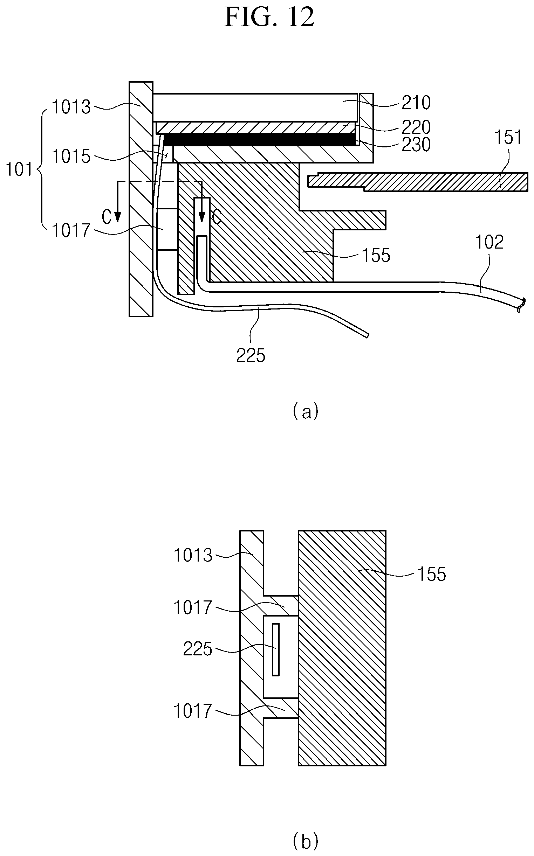

The display device 100 may include a display module 151 configured to output an image, a top casing 101 covering a peripheral region of a front surface and a side surface of the display module 151, and a cover bottom 102 (FIG. 12) covering a rear surface of the display module 151.

The top casing 101 may include a front portion 1011 and a side portion 1013. The front portion 1011 may be disposed around the front surface of the display module 151 to cover a non-display region of the display module 151, and the side portion 1013 may be disposed around and cover the side surface of the display module 151 and may be arranged perpendicular to the front portion 1011.

The front portion 1011 of the top casing 101 covers the non-display region of the display module 151 and may also be referred to as a bezel. As the size of the non-display region of the display module 151 decreases, the size of the bezel also tends to decrease accordingly.

As the size of the display device 100 increases and the display device 100 occupies a large area in an indoor space, exterior design, in addition to performance, has become an important marketing point of the product. In the display device 100, the most important part from a design standpoint is the front portion 1011 of the top casing 101, which is most visually exposed, and the color of the front portion 1011 determines the overall design framework of the display device 100.

Accordingly, the display device 100 of the present disclosure is characterized by including a skin panel 200 so that the color of the front portion 1011 of the top casing 101 can be changed. The skin panel 200 may include electronic paper 220 (e-skin) so that the color of the skin panel 200 is variable.

The skin panel 200 may be additionally attached to the front portion 1011 of the top casing 101 and may have a rectangular frame shape with an open interior to expose a display region of the display module 151.

Implementing the skin panel 200 as one integrated rectangular frame with an open interior increases manufacturing costs and the volume occupied when components are stored. Accordingly, as illustrated, the display device 100 of the present disclosure may include four bar-shaped skin panels 200a and 200b arranged at right angles to one another to form the skin panel 200 having a rectangular frame shape.

At each corner of the top casing 101, the end portions 201 and 202 of the respective skin panels 200 meet, and each skin panel 200 should be capable of forming a continuous appearance with an adjacent skin panel 200.

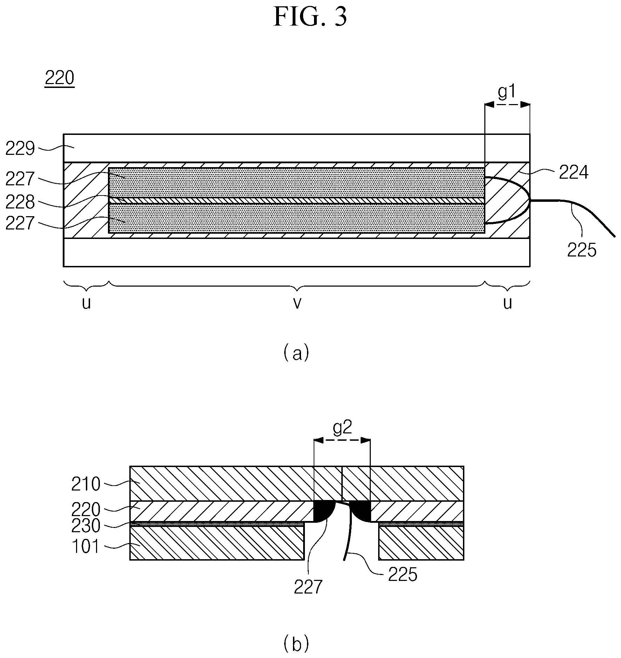

FIG. 3 is a cross-sectional view illustrating the skin panel 200 of the display device 100 according to the present disclosure. (a) in FIG. 3 is a cross-sectional view of the electronic paper 220. Compared with a liquid crystal display or a conventional display panel, the electronic paper 220 is thinner, is easier to operate, has lower manufacturing costs, and does not use a light source and thus does not emit blue light toward a user's eyes.

In addition, the electronic paper 220 requires power only when a color is to be changed and does not require power to maintain the color after the color has been changed, thereby minimizing power consumption.

The electronic paper 220 may include a color layer 228 representing a color and disposed between a pair of electrode layers 227. The color layer 228 may be switched to a different color according to power supplied to the electrode layers 227, thereby allowing a user to change the bezel of the display device 100 to a desired color.

The electronic paper 220 may include protective layers 229 on front and rear surfaces thereof and a sealing portion 224 on a side surface thereof to seal the electronic paper 220 so as to prevent moisture from penetrating into the electronic paper 220. Because the sealing portion 224 covers a side surface of the color layer 228 configured to output a color, the electronic paper 220 includes a non-display edge u disposed around a display region v in which the color is output.

As illustrated in (b) in FIG. 3, at a location where the skin panels 200 are adjacent to each other, the non-display edges u from which no color is output abut each other, thereby forming a gap g2. In addition, an end portion of the electronic paper 220 to which a signal line 225 for applying power to the electrode layers 227 is connected requires additional space to prevent the signal line 225 from being bent.

Accordingly, the gap has a size equal to or greater than twice a width g1 of the non-display edge u (g2 > 2 * g1). When the gap between adjacent skin panels 200 is large, the respective skin panels 200 are individually perceived, making it difficult to form a unified appearance.

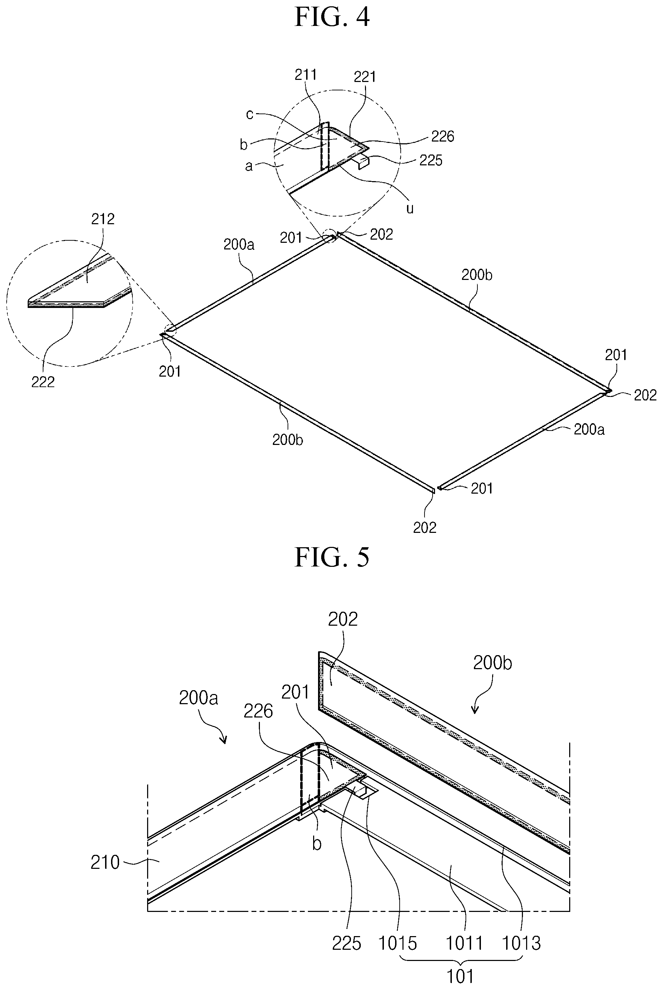

To address the above problem, the skin panels 200 may be arranged to overlap each other at corners of the display device 100 where the skin panels 200 meet. By disposing the non-display edge u of a first end portion 221 of the electronic paper 220 under an adjacent skin panel 200, the gap g2 between the display regions v can be reduced to approximately the size g1 of the non-display edge u. FIG. 4 is a view illustrating the skin panel 200 according to a first embodiment of the display device 100 of the present disclosure. As described above, four bar-shaped skin panels 200 may be arranged at right angles to one another to implement a rectangular frame. Due to the rectangular shape of the display device 100, a pair of first skin panels 200a extending in the vertical direction may have the same length and shape, and a pair of second skin panels 200b extending in the horizontal direction may have the same length and shape.

As illustrated in FIG. 2, portions meeting adjacent skin panels 200 may form diagonal lines at the corners of the top casing 101. In the present embodiment, the first skin panels 200a arranged in the vertical direction and the second skin panels 200b arranged in the horizontal direction differ only in length and have end portions of the same shape.

Hereinafter, the term "end portion" is used to include not only an edge of the skin panel 200 in a longitudinal direction but also a region adjacent to the edge.

Each skin panel 200 may include a decoration sheet 210 attached to a front surface of the electronic paper 220 and protecting the electronic paper 220, and double-sided tape 230 disposed on a rear surface of the electronic paper 220 and fixing the electronic paper 220 to the front portion 1011 of the top casing 101.

The decoration sheet 210 covers the front surface of the electronic paper 220 and constitutes an outer surface of the bezel. The decoration sheet 210 may be attached to the front surface of the electronic paper 220 using an optically clear adhesive (OCA) layer.

The decoration sheet 210 is thicker than the electronic paper 220 and has predetermined rigidity. For front surfaces of adjacent skin panels 200 to be coplanar, the decoration sheets 210 may be disposed adjacent to and abutting each other without overlapping each other.

Both opposing end portions of each decoration sheet 210, namely, a first end portion 211 and a second end portion 212, each include an oblique edge, and the first end portion 211 of the decoration sheet 210 abuts the second end portion 212 of the decoration sheet 210 of an adjacent skin panel 200 at a corner C1, C2, C3, or C4 of the display device 100.

The electronic paper 220 is flexible because it has the form of a thin film. Using the flexibility of the electronic paper 220, the first end portion 221 of the electronic paper 220 may extend beyond the first end portion 211 of the decoration sheet 210 and may be disposed under the second end portion 212 of the decoration sheet 210 of an adjacent skin panel 200.

The first end portion 201 of each skin panel 200 is disposed adjacent to the second end portion 202 of an adjacent skin panel 200. The four skin panels 200a and 200b of the present embodiment are arranged such that all of the first end portions 201 are positioned in a clockwise direction. As illustrated in FIG. 4, the pair of first skin panels 200a may be arranged in vertically opposite orientations, and the pair of second skin panels 200b may be arranged in horizontally opposite orientations.

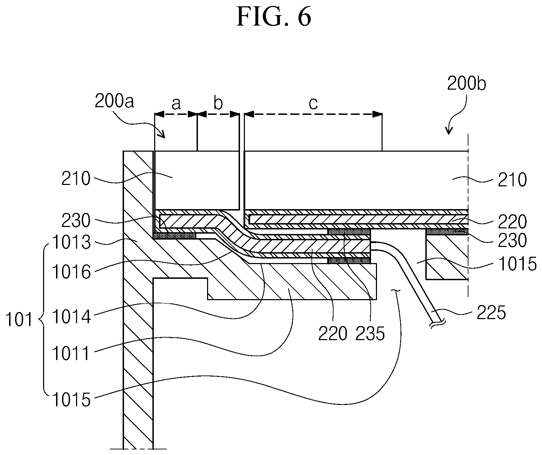

FIG. 5 is an exploded perspective view illustrating a corner portion according to the first embodiment of the display device 100 of the present disclosure, and FIG. 6 is a cross-sectional view taken along line A-A of FIG. 2.

Referring to FIG. 5, the first end portion 201 of the first skin panel 200a and the second end portion 202 of the second skin panel 200b are illustrated, and the first end portion 201 and the second end portion 202 of the second skin panel 200b may also be arranged in a similar form.

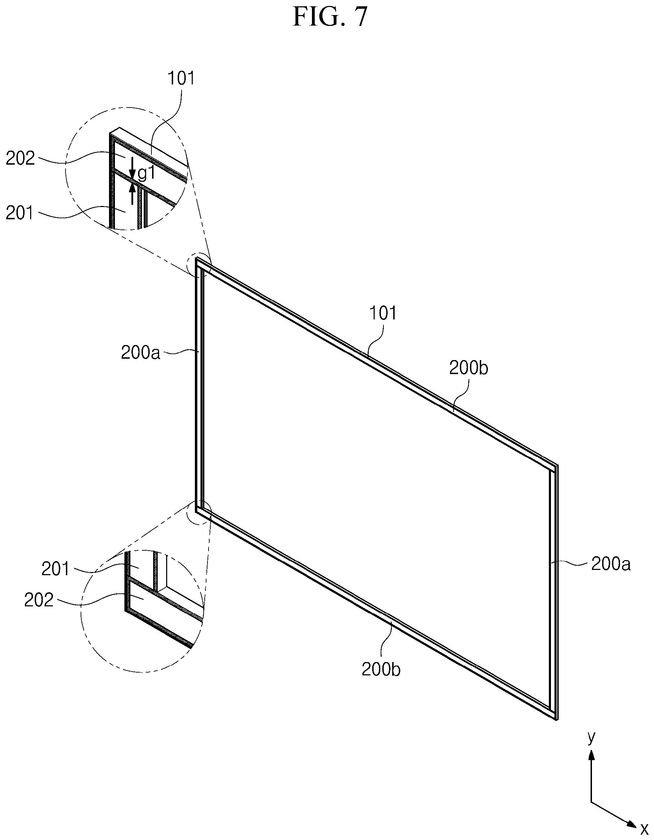

The first end portion 221 of the electronic paper 220 may include an extension portion 226 protruding beyond the first end portion 211 of the decoration sheet 210. The shape of the extension portion 226 is not limited and may be triangular as in the present embodiment or rectangular as in the second embodiment illustrated in FIG. 7.

As illustrated in FIG. 6, the extension portion 226 may be disposed under the second end portion 202 of an adjacent skin panel 200. The signal line 225 for applying a signal to the electronic paper 220 is connected to the extension portion 226. As illustrated in FIG. 5, the signal line 225 may pass through a hole 1015 formed in the front portion 1011 of the top casing 101 and may be connected to a controller (not shown) disposed at a rear of the display device 100.

To prevent the second end portion of the adjacent skin panel 200 overlapping the front surface of the extension portion 226 from lifting, the display device 100 may further include a lifting-prevention tape 235 coupled to the front surface of the extension portion 226 and a rear surface of the skin panel 200 disposed on top of the extension portion 226.

The lifting-prevention tape 235 may be formed continuously with the double-sided tape 230 described above or may be disposed only in an overlapping area c as illustrated in FIG. 6.

The front portion 1011 of the top casing 101 may include a recess 1014 recessed therein in a rearward direction at a position corresponding to the extension portion 226. The recess 1014 may be larger than the extension portion 226 and may be recessed by a depth corresponding to a combined thickness of the extension portion 226 and the lifting-prevention tape 235 for fixing the extension portion 226.

To prevent the extension portion 226 of the electronic paper 220 from being sharply bent and the electronic paper 220 from being damaged, the electronic paper 220 may be gently bent and disposed in the recess 1014. As illustrated in FIG. 6, the recess 1014 may include an inclined portion 1016 and may form a height difference from the front portion 1011 of the top casing 101.

The first end portion 211 of the decoration sheet 210 is arranged to abut the second end portion 212 of an adjacent decoration sheet 210 as illustrated in FIG. 6. In this case, when the decoration sheet 210 is attached to the electronic paper 220 with the optically clear adhesive layer up to the edge of the first end portion 211 of the decoration sheet 210, the extension portion 226 of the electronic paper 220 may be bent at the first end portion 211 of the decoration sheet 210, which may damage the electronic paper 220.

As illustrated in FIG. 6, a first end portion of the optically clear adhesive layer may be positioned toward the second end portion by a predetermined distance (approximately 5 mm) from the first end portion 211 of the decoration sheet 210 such that the electronic paper 220 overlaps with a gentle incline. The electronic paper 220 may include a non-adhesive portion b that is not attached to the decoration sheet 210. As illustrated in FIG. 6, the non-adhesive portion b may be spaced apart from the decoration sheet 210 and may be bent with a gentle incline toward the recess 1014.

Referring to FIGS. 4 and 6, the first end portion of the electronic paper 220 may include an adhesive portion a at which the electronic paper 220 and the decoration sheet 210 are attached by the optically clear adhesive layer, a non-adhesive portion b at which the electronic paper 220 is not attached by the optically clear adhesive layer to the decoration sheet 210 disposed on the front surface of the electronic paper 220, and an extension portion c protruding beyond the decoration sheet 210 and disposed under an adjacent skin panel 200.

The side portion 1013 of the top casing 101 may protrude in a frontward direction beyond the front portion 1011 by a distance corresponding to a thickness of the skin panel 200.

FIG. 7 is a view illustrating the skin panel 200 according to a second embodiment of the display device 100 of the present disclosure. The skin panel 200 of the present embodiment has rectangular end portions, and thus a short side of a first skin panel 200a may abut a long side of a second skin panel 200b.

For a left-right symmetric structure, both opposing end portions of the second skin panel 200b may extend to the side portion 1013 of the top casing 101, and the first skin panel 200a may extend only until the first skin panel 200a abuts the long side of the second skin panel 200b.

Unlike the embodiment described above, the display device 100 of the present embodiment may have a difference between the shapes of the first end portions 211 of the first skin panel 200a and the second skin panel 200b.

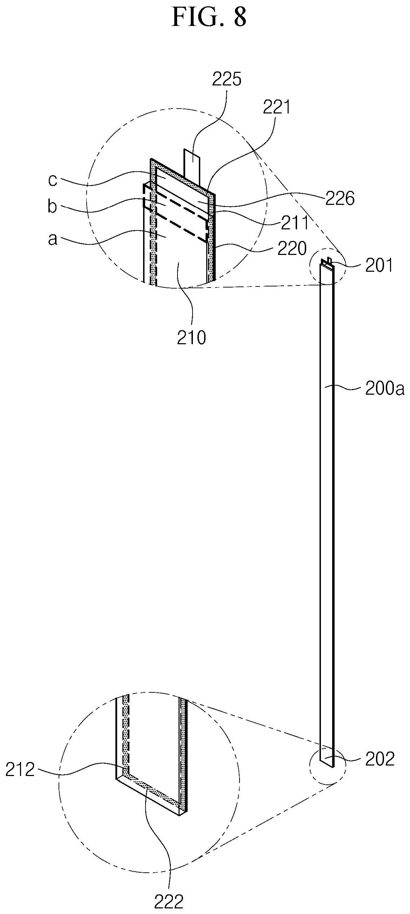

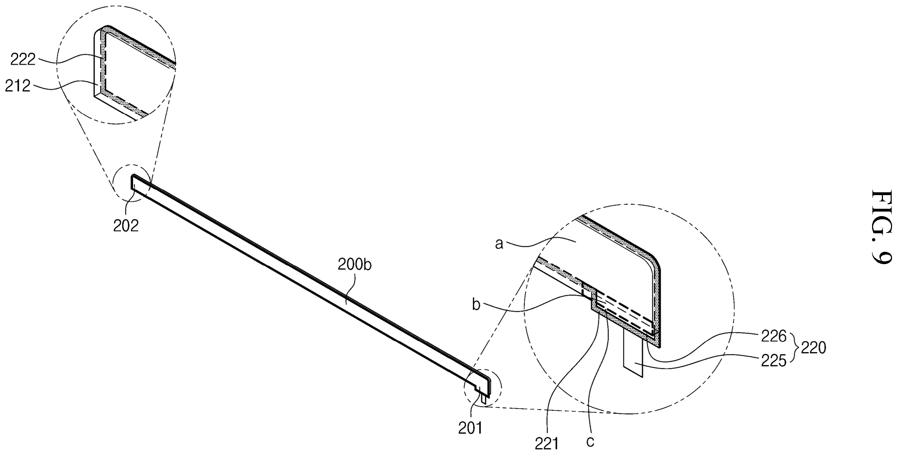

FIG. 8 is a view illustrating the first skin panel 200a according to the second embodiment of the display device 100 of the present disclosure, and FIG. 9 is a view illustrating the second skin panel 200b according to the second embodiment of the display device 100 of the present disclosure.

FIG. 8 illustrates the left first skin panel 200a having the first end portion 211, at which the extension portion 226 and the signal line 225 are located, facing upward, and the right first skin panel 200a may be arranged such that the first end portion 211 thereof faces downward.

FIG. 9 illustrates the lower second skin panel 200b having the first end portion 211, at which the extension portion 226 and the signal line 225 are located, facing rightward, and the upper second skin panel 200b may be arranged such that the first end portion 211 thereof faces leftward.

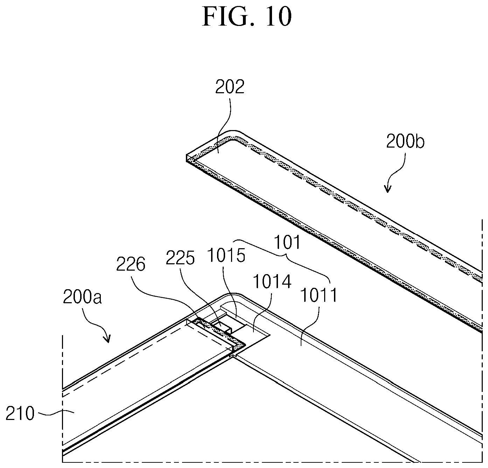

FIG. 10 is an exploded perspective view illustrating a corner portion of the skin panel 200 according to the second embodiment of the display device 100 of the present disclosure and illustrates an overlapping portion between the first end portion 201 of the first skin panel 200a and the second end portion 202 of the second skin panel 200b.

The only difference is that the extension portion 226 is also rectangular because the end portion of the decoration sheet 210 is rectangular rather than inclined, and the basic configuration in which the extension portion 226 is disposed on a rear surface of an adjacent skin panel 200 is the same. The present embodiment also includes a non-adhesive portion b so that the electronic paper 220 can be bent with a gentle incline toward the recess 1014, and a cross-sectional shape of the overlapping portion may be divided into three sections a, b, and c, similar to that illustrated in FIG. 6.

Because the decoration sheet 210 of the second skin panel 200b of FIG. 9 abuts the side portion 1013 of the top casing 101, the extension portion 226 of the electronic paper 220 cannot extend farther in the longitudinal direction and may protrude in a perpendicular direction toward the second end portion of an adjacent first skin panel 200a. Only the direction of the extension portion 226 differs, and the overlapping structure is the same as the feature described above.

This structure can prevent a gap between the display regions v from increasing due to the non-display edge u and the signal line 225 being disposed, as illustrated in FIG. 3(b), at a location where the first skin panel 200a and the second skin panel 200b abut each other. That is, a gap having a size corresponding to the size g1 of the non-display edge may be implemented at the location where the first skin panel 200a and the second skin panel 200b abut each other.

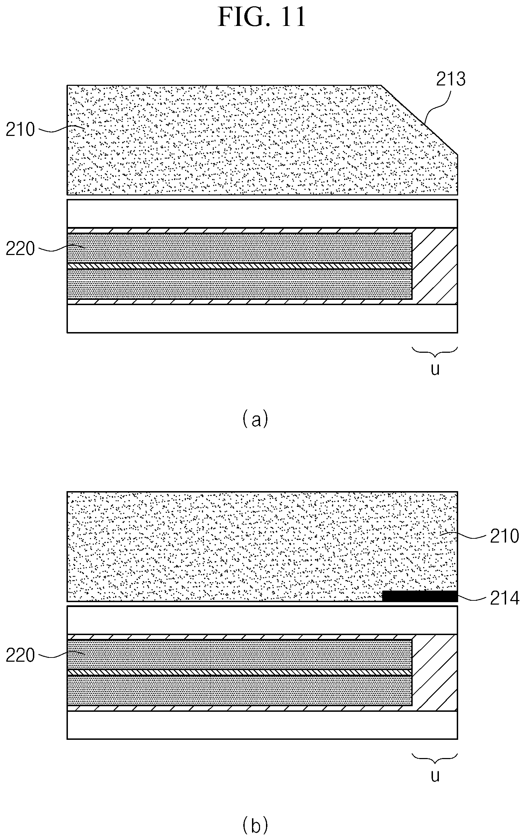

FIG. 11 is a cross-sectional view illustrating the skin panel 200 of the display device 100 according to the present disclosure. The decoration sheet 210 may further include a structure configured to conceal the non-display edge in an area corresponding to the non-display edge.

As illustrated in (a) in FIG. 11, the decoration sheet 210 may include a chamfer 213 formed in an edge of a front surface thereof in an area corresponding to the non-display edge u. The chamfer 213 is an inclined surface formed obliquely and may refract light to prevent the non-display edge u from being visually exposed. Alternatively, as illustrated in (b) in FIG. 11, a printing portion 214 may be formed on a rear surface of the decoration sheet 210 to cover the non-display edge u.

FIG. 12 is a cross-sectional view illustrating an edge portion of the display device 100 according to the present disclosure. (a) in FIG. 12 is a cross-sectional view taken along line B-B of FIG. 2, and (b) in FIG. 12 is a cross-sectional view taken along line C-C of (a) in FIG. 12.

The signal line 225 extending in a rearward direction through the hole 1015 formed in the recess 1014 of the top casing 101 may pass through a space between a side surface of the display module 151 and the side portion 1013 of the top casing 101 and may be connected to a controller (not shown) disposed on a rear surface of the cover bottom 102.

The display device 100 may further include a gap rib 1017 protruding from the side portion 1013 and maintaining a constant gap between the side portion 1013 of the top casing 101 and a side surface of the display module 151 to prevent the signal line 225 from being compressed or damaged. The gap rib 1017 protruding from the side portion 1013 of the top casing 101 may contact a side surface of the display module 151, or a side surface of a guide panel 155 in the drawing, and a plurality of gap ribs 1017 may be provided.

As described above, the display device 100 according to an aspect of the present disclosure may improve an aesthetic effect by changing the color around the front surface of the display device 100.

In addition, the display device 100 according to an aspect of the present disclosure may reduce the manufacturing costs of the skin panels 200 by arranging four modular skin panels 200 at right angles to one another to implement a rectangular frame structure.

In addition, the display device 100 according to an aspect of the present disclosure may be driven with low power using the electronic paper 220 and may provide a unified design by minimizing a gap caused by the non-display edges u between the skin panels 200.

The above embodiments are to be construed in all aspects as illustrative and not restrictive. The scope of the disclosure should be determined by the appended claims and their legal equivalents, not by the above description, and all changes coming within the meaning and equivalency range of the appended claims are intended to be embraced therein.

### [MODE FOR CARRYING OUT THE INVENTION]

Regarding various embodiments for implementing the present disclosure, descriptions that are redundant with those described above in the previous section on the best form for carrying out the invention are omitted.

### [INDUSTRIAL APPLICABILITY]

Since the present disclosure is applicable to display devices in various fields, industrial applicability is recognized.

## Claims

1. A display device comprising:
a display module;
a top casing including a front portion covering a peripheral region of a front surface of the display module and a side portion disposed around and covering a side surface of the display module; and
four bar-shaped skin panels disposed on the front portion, adjacent ones of the four skin panels being arranged at right angles to each other and disposed to overlap each other at corners of the top casing,
wherein each of the four skin panels includes:
electronic paper configured to output a specific color or image according to a signal;
a transparent decoration sheet disposed on a front surface of the electronic paper; and
a double-sided tape disposed on a rear surface of the electronic paper and fixing the electronic paper to the front portion.

2. The display device of claim 1, wherein the electronic paper includes:
an extension portion protruding from a first end portion of the electronic paper beyond the decoration sheet and disposed under the electronic paper of a skin panel adjacent thereto so as to overlap therewith; and
a signal line extending from the extension portion.

3. The display device of claim 2, wherein the front portion of the top casing includes a hole through which the signal line passes.

4. The display device of claim 3, wherein the signal line passes through a space between the side surface of the display module and the side portion of the top casing and is connected to a controller disposed on a rear surface of the display module.

5. The display device of claim 4, further comprising a gap rib protruding from the side portion of the top casing and maintaining a gap between the side portion of the top casing and the side surface of the display module to provide the space through which the signal line passes.

6. The display device of claim 2, wherein the front portion of the top casing includes a recess recessed therein in a rearward direction at a position corresponding to the extension portion of the electronic paper, and
wherein the recess includes an inclined portion formed in an area along which the extension portion extends.

7. The display device of claim 2, wherein a second end portion of the electronic paper has a shape corresponding to a shape of a second end portion of the decoration sheet, and
wherein the extension portion is disposed under a second end portion of the skin panel adjacent thereto.

8. The display device of claim 2, further comprising a lifting-prevention tape coupled to a front surface of the extension portion and
a rear surface of the skin panel disposed on top of the extension portion.

9. The display device of claim 2, wherein both opposing end portions of the decoration sheet each include an oblique edge inclined with respect to a longitudinal direction of the decoration sheet so as to abut an end portion of an adjacent decoration sheet at a corner of the top casing, and
wherein the extension portion protrudes in a triangular shape from a first end portion of the decoration sheet.

10. The display device of claim 1, wherein the skin panels include:
a pair of first skin panels in each of which both opposing end portions of the decoration sheet face the side portion of the top casing; and
a second skin panel disposed between the pair of first skin panels, wherein both opposing end portions of the decoration sheet of the second skin panel respectively abut the decoration sheets of the first skin panels adjacent thereto.

11. The display device of claim 1, further comprising an optically clear adhesive (OCA) layer disposed between the decoration sheet and the electronic paper,
wherein a first end portion of the optically clear adhesive layer is positioned closer to a second end portion of the decoration sheet than a first end portion of the decoration sheet is.

12. The display device of claim 1, wherein the electronic paper includes:
a display region in which a specific color or image is output; and
a non-display edge disposed around the display region,
wherein the decoration sheet includes a chamfer formed in an edge of a front surface thereof in an area corresponding to the non-display edge.

13. The display device of claim 1, wherein the side portion of the top casing protrudes in a frontward direction beyond the front portion by a distance equal to or greater than a height of the skin panel.
